Europäisches Patentamt

(19) European Patent Office

Office européen des brevets

(11) Numéro de publication : **0 183 574 B1**

(12) **FASCICULE DE BREVET EUROPÉEN**

(45) Date de publication du fascicule du brevet : 17.05.89

(51) Int. Cl.⁴ : **H 03 F 3/191**

(21) Numéro de dépôt : 85401876.9

(22) Date de dépôt : 25.09.85

(54) Amplificateur large bande VHF-UHF pefectionné et dispositif de traitement de signaux incorporant celui-ci, notamment pour signaux de télévision.

(30) Priorité : 27.09.84 FR 8414863

(43) Date de publication de la demande : 04.06.86 Bulletin 86/23

(45) Mention de la délivrance du brevet : 17.05.89 Bulletin 89/20

(84) Etats contractants désignés : AT BE CH DE FR GB IT LI LU NL SE

(56) Documents cités :
US–A– 3 204 192
US–A– 4 225 827
US–A– 4 465 979
TECHNISCHE MITTEILUNGEN AEG - TELEFUNKEN, vol. 61, no. 6, 1971, pages 345-350;W. GEIDEL: "Ein breitbandiger UHF-Leistungsverstärker mit 100W Ausgangsleistung"
INSTRUMENTS AND EXPERIMENTAL TECHNIQUES, Original en Russe, vol. 15, no. 3, partie 1, mai-juin 1972, pages 768-769, traduction publiée novembre 1972, Consultants Bureau, New York, US; V.I. ZHAVO-RONKOV et al.: "Transistor microwave amplifier having a passband of 1 to 1000 MHz"
JOURNAL OF THE INSTITUTION OF ELECTRONICS AND TELECOMMUNICATION ENGINEERS, vol. 21, no. 12, décembre 1975, pages 645-648, The Institution of Electronics and Telecommunication Engineers, New Delhi, IN; M.L. SHARMA et al.: "Low-noise transistor amplifier for troposcatter communication system"

(73) Titulaire : **TONNA ELECTRONIQUE**
**36, avenue Hoche -Z.I.S.-E.**
**F-51000 Reims (FR)**

(72) Inventeur : **Dumoulin, Gérard Roger Marcel**
**3, rue de Varsovie**
**F-57210 Maizieres Les Metz (FR)**

(74) Mandataire : **Martin, Jean-Jacques et al**
**Cabinet REGIMBEAU 26, Avenue Kléber**
**F-75116 Paris (FR)**

## Description

La présente invention concerne un circuit amplificateur de signaux électriques couvrant une large bande prédéterminée de fréquences.

La présente invention concerne plus précisément la transmission et l'amplification de signaux dans les bandes dites VHF-UHF (Very High Frequency - Ultra High Frequency) allant de 40 MHz à 960 MHz.

La présente invention s'applique en particulier à l'amplification de signaux de télévision, dont la largeur de bande couvre, pour chaque canal, plusieurs Megahertz.

L'invention sera décrite par la suite dans le cadre de cette application aux signaux de télévision sans que cette application toutefois puisse être considérée comme limitative.

D'une façon générale, il serait souhaitable de disposer de circuits amplificateurs large bande opérant dans les bandes VHF-UHF.

On a déjà proposé différents circuits amplificateurs à large bande notamment sous forme de circuits hybrides, adaptés pour la transmission de signaux des bandes VHF-UHF.

De tels circuits sont par exemple décrits dans le manuel « Wideband Transistors and Wideband Hybrid IC Modules », Sept. 81 édité par Philips.

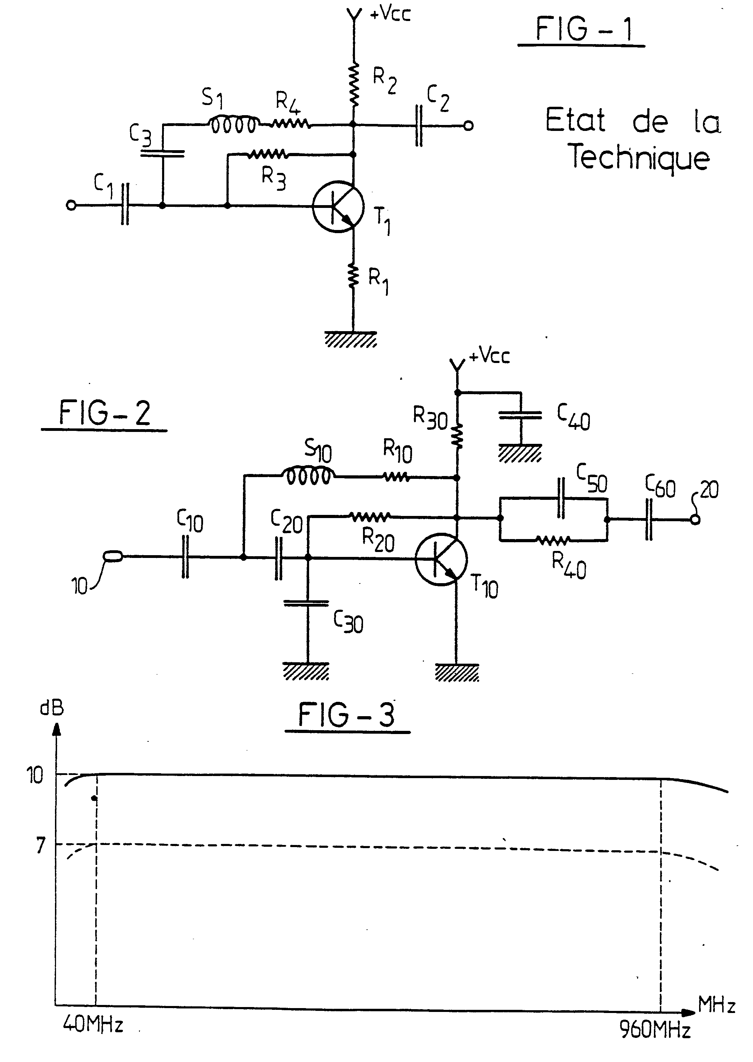

Comme cela est représenté sur la figure 1 annexée, qui illustre l'état de la technique, ces circuits amplificateurs classiques comprennent généralement un transistor amplificateur $T_1$ dont la base reçoit le signal à amplifier par l'intermédiaire d'un condensateur de liaison d'entrée $C_1$.

L'émetteur du transistor $T_1$ est relié à la masse du montage par l'intermédiaire d'une résistance $R_1$ formant contre-réaction en courant. Le collecteur du transistor $T_1$ est relié à une borne d'alimentation positive + Vcc par l'intermédiaire d'une résistance de charge $R_2$ qui fixe le courant de polarisation du transistor $T_1$, en combinaison avec une résistance $R_3$ de polarisation, de forte valeur, reliant le collecteur et la base du transistor $T_1$.

Le signal amplifié est prélevé sur le collecteur du transistor $T_1$ par l'intermédiaire d'un condensateur de liaison $C_2$.

Enfin, une boucle de contre-réaction en tension est branchée en parallèle sur la résistance $R_3$ entre le collecteur et la base du transistor $T_1$. Cette boucle de contre-réaction comprend en série, comme représenté sur la figure 1, une résistance $R_4$ de faible valeur — 220 Ω par exemple, une self $S_1$ et un condensateur $C_3$.

Un grand nombre de ces circuits a déjà été utilisé.

On constate cependant, dans la pratique que les systèmes jusqu'ici proposés ne donnent pas entière satisfaction dans la mesure, en particulier où leur facteur de bruit limite de façon importante leur utilisation dans les dispositifs de réception. De ce fait, il était nécessaire jusqu'ici, dans la plupart des cas, d'adjoindre un étage supplémentaire à faible bruit, au circuit précédemment décrit.

Le document « Instruments and Experimental Techniques », vol. 15, n° 3, partie 1, mai-juin 1972, pages 768-769 décrit un amplificateur à large bande de signaux électriques, notamment pour le canal de déviation verticale d'un oscilloscope, qui comprend un ensemble amplificateur pourvu d'un étage amplificateur à transistor non contre-réactionné en courant et d'un réseau d'adaptation d'entrée, ainsi qu'un réseau d'adaptation de sortie.

La présente invention vient maintenant proposer un nouveau circuit amplificateur large bande de signaux électriques VHF-UHF qui présente en particulier des caractéristiques de bruit, de gain de transmission, de linéarité et de niveau de sortie, sur toute la bande considérée, nettement améliorées par rapport aux réalisations antérieures.

A cet effet, la présente invention propose un circuit amplificateur large bande de signaux électriques VHF-UHF qui comprend de façon connue en soi au moins :

un ensemble amplificateur comportant

un étage amplificateur à transistor non contre-réactionné en courant dans la bande d'utilisation, et

un réseau d'adaptation d'entrée,

un réseau d'adaptation de sortie, caractérisé en ce qu'une boucle de contre-réaction en tension agit sur l'ensemble amplificateur composé de l'étage amplificateur à transistor et du réseau d'adaptation d'entrée.

Selon l'invention, les réseaux d'entrée et de sortie sont adaptés pour favoriser la transmission de signaux électriques des bandes VHF-UHF et atténuer au moins les signaux électriques de fréquence inférieure à la bande d'utilisation.

La Demanderesse a ainsi remarqué qu'en utilisant des étages amplificateurs à transistors non-contre réactionnés en courant, à l'opposé des réalisations antérieures qui proposaient des contre-réactions sur lesdits étages amplificateurs, et dans la grande majorité des cas, des contre-réactions simultanément en tension et en courant, les caractéristiques de bruit et de gain des circuits amplificateurs étaient très nettement améliorées.

En outre, et surtout le fait d'inclure le réseau d'adaptation d'entrée dans la boucle de contre-réaction en tension, selon l'invention, permet de linéariser la réponse amplitude/fréquence du circuit amplificateur sur une gamme de fréquences aussi large que les bandes VHF-UHF.

Selon une caractéristique avantageuse de la présente invention, les transistors des étages amplificateurs sont montés en émetteur commun.

Selon une autre caractéristique avantageuse de l'invention, le circuit amplificateur comprend un circuit d'adaptation de la sortie constitué d'un réseau parallèle résistance-capacité qui relie le collecteur du transistor à la sortie du circuit amplificateur. Cette disposition permet notamment d'obtenir une bonne linéarité du circuit amplificateur, en optimisant le gain aux fréquences élevées de la bande UHF.

De façon avantageuse, la boucle de contre-réaction en tension et le réseau d'adaptation d'entrée sont adaptés pour fixer en combinaison l'impédance d'entrée du circuit amplificateur et linéariser la réponse de celui-ci dans la partie inférieure de la bande d'utilisation. Le réseau d'adaptation de sortie fixe l'impédance de sortie du circuit.

Par ailleurs, de façon préférentielle, le réseau d'adaptation d'entrée comprend deux capacités connectées en série entre l'entrée du circuit et la masse, le point commun médian des capacités étant relié à la base du transistor.

La boucle de contre-réaction comprend avantageusement en série une résistance et une self.

En outre, selon une caractéristique très importante de la présente invention, le circuit amplificateur précité pourra être réalisé en technologie hybride. La réalisation des circuits amplificateurs précités, en technologie hybride, comme cela est proposé par la Demanderesse, permet en particulier de résoudre, avec une bonne reproductibilité, les problèmes de bruit, de gain et de niveau de sortie jusqu'ici posés avec les circuits amplificateurs classiques, tout en conservant une bonne linéarité de la réponse amplitude/fréquence.

Enfin, on remarquera que la présente invention concerne également les dispositifs de traitement de signaux électriques, en particulier des dispositifs de réception, par exemple de signaux de télévision, qui comprennent au moins un circuit amplificateur du type précité.

D'autres caractéristiques et avantages de la présente invention apparaîtront à la lecture de la description détaillée qui va suivre et en regard des dessins annexés donnés à titre d'exemple non limitatif, sur lesquels, la figure 1 qui illustre l'état de la technique ayant déjà été décrite,

la figure 2 représente le schéma général d'un circuit amplificateur conforme à la présente invention,

la figure 3 représente en trait plein un graphe illustrant le gain (mesuré en dB) en fonction de la fréquence exprimée en MHz d'un circuit amplificateur conforme à la présente invention et représente en traits interrompus un graphe semblable obtenu avec un circuit amplificateur classique.

L'amplificateur représenté sur la figure 2 est destiné à amplifier des signaux des bandes VHF-UHF appliqués sur l'entrée référencée 10 et représentée sur la gauche de la figure 2, les signaux amplifiés par le circuit étant prélevés sur la sortie référencée 20 et représentée sur la droite de la figure 2. Bien entendu, les connexions d'entrée 10 et de sortie 20 seront de préférence réalisées par câble coaxial.

D'une façon générale, on reconnaît sur la figure 2, un étage amplificateur comportant un transistor $T_{10}$. Plus précisément, on aperçoit sur la figure 2 un réseau d'adaptation d'entrée formé, selon le mode de réalisation représenté, de deux capacités référencées $C_{20}$, $C_{30}$ connectées en série entre l'entrée du montage et la masse. Plus précisément encore, les capacités $C_{20}$ et $C_{30}$ sont reliées à l'entrée 10 du circuit par l'intermédiaire d'une capacité de liaison d'entrée $C_{10}$. Le point commun aux deux capacités du réseau d'adaptation $C_{20}$, $C_{30}$ est relié à la base du transistor $T_{10}$. Le filtre d'entrée ainsi formé par les capacités $C_{20}$ et $C_{30}$ permet d'éliminer les fréquences inférieures à la bande utilisée et d'autre part contribue à linéariser la réponse amplitude/fréquence et à fixer l'impédance d'entrée de l'amplificateur dans toute la bande. Le Transistor $T_{10}$ est monté en émetteur commun, ledit émetteur étant connecté directement à la masse. Comme cela a été précédemment évoqué, ceci apporte comme avantage une augmentation importante du gain de l'étage ainsi qu'une amélioration très sensible du facteur de bruit par rapport aux propositions antérieures dans lesquelles les transistors étaient contre-réactionnés en courant.

Une résistance de polarisation $R_{20}$ de très forte valeur est branchée entre le collecteur et la base du transistor $T_{10}$.

La contre-réaction en tension, due à la résistance $R_{20}$ de très forte valeur, est tout à fait négligeable. Par contre, l'ensemble série résistance $R_{10}$, self $S_{10}$ représenté sur la figure 2 connecté entre le collecteur du transistor $T_{10}$ et le point commun des capacités $C_{10}$, $C_{20}$ apporte une contre-réaction de tension au travers du réseau d'entrée $C_{20}$, $C_{30}$ plus particulièrement aux fréquences comprises dans la bande VHF. Dans la bande UHF, la présence de $S_{10}$ permet de linéariser la réponse amplitude-fréquence de l'amplificateur, et contribue à l'adaptation des impédances d'entrée et de sortie de l'amplificateur.

Enfin, le réseau d'adaptation de sortie constitué de la résistance $R_{40}$ en parallèle avec la capacité $C_{50}$ connecté entre le collecteur du transistor $T_{10}$ et la sortie 20 de l'amplificateur, par l'intermédiaire d'une capacité de liaison de sortie $C_{60}$ en série, contribue à linéariser la réponse amplitude-fréquence de l'amplificateur et à adapter l'impédance de sortie dans la bande d'utilisation.

Les capacités $C_{10}$ et $C_{60}$ de forte valeur servent à isoler l'amplificateur en entrée et en sortie.

La résistance $R_{30}$, qui charge le collecteur du transistor $T_{10}$, et relie celui-ci à la tension positive d'alimentation + Vcc, en association avec la résistance $R_{20}$ fixe le courant de polarisation du transistor.

La tension positive d'alimentation + Vcc est découplée à la masse grâce à une capacité $C_{40}$.

En raison de la structure du circuit proposé, l'élément selfique $S_{10}$ présente une inductance relativement faible ce qui autorise la réalisation de cet élément selfique sous forme de circuits imprimés. De ce fait, selon une caractéristique très importante de la présente invention, le circuit amplificateur peut être réalisé sous forme de technologie hybride. Outre des caractéristiques de gain et de linéarité exceptionnelles, la présente invention permet ainsi d'obtenir un facteur de bruit et un niveau de sortie très proches de ceux annoncés par les constructeurs pour les transistors.

Les domaines d'application du circuit amplificateur conforme à la présente invention sont notamment la réception et le traitement des signaux des bandes VHF-UHF (40-960 MHz).

Selon un mode de réalisation particulier, non limitatif, à un étage amplificateur d'un circuit amplificateur conforme à la présente invention :

le transistor $T_{10}$ est du type BFR 91A ou BFR 93A commercialisé par RTC,

les condensateurs $C_{10}$ à $C_{60}$ ont les valeurs suivantes :

$C_{10}$, $C_{40}$ et $C_{60}$ = 1 000 pF,
$C_{20}$ = 15 pF,
$C_{30}$ = 2,7 pF,
$C_{50}$ = 4,7 pF

les résistances $R_{10}$ à $R_{40}$ ont les valeurs suivantes :

$R_{10}$ = 470 $\Omega$
$R_{20}$ = 18 K$\Omega$
$R_{30}$ = 1 K$\Omega$
$R_{40}$ = 47$\Omega$.

Ce circuit amplificateur a permis d'obtenir les performances suivantes :

gain : 10 dB $\pm$ 1 dB dans la bande 40-960 MHz (comme cela est représenté sur la figure 3),

facteur de bruit : F $\leqslant$ 3 dB dans la bande 100-960 MHz,

niveau de sortie : 107 dB$\mu$V à $-$ 52 dB d'intermodulation d'ordre 3 (mesuré à 3 porteuses dont 2 atténuées de 6 dB).

Bien entendu, la présente invention n'est pas limitée au mode de réalisation décrit mais s'étend à toute variante conforme à son esprit, en particulier on notera qu'un nombre d'étages supérieur à un est susceptible d'être retenu.

## Revendications

1. Circuit amplificateur large bande de signaux électriques, notamment pour bandes VHF-UHF, du type comprenant au moins :
   un ensemble amplificateur comportant
   un étage amplificateur à transistor ($T_{10}$) non contre-réactionné en courant dans la bande d'utilisation, et
   un réseau d'adaptation d'entrée ($C_{20}$, $C_{30}$),
   un réseau d'adaptation de sortie ($C_{50}$, $R_{40}$), caractérisé par le fait qu'il comprend en outre une boucle de contre-réaction en tension ($S_{10}$, $R_{10}$) agissant sur l'ensemble amplificateur composé de l'étage amplificateur à transistor ($T_{10}$) et du réseau d'adaptation d'entrée ($C_{20}$, $C_{30}$).

2. Circuit amplificateur selon la revendication 1, caractérisé par le fait que lesdits réseaux d'entrée ($C_{20}$, $C_{30}$) et de sortie ($C_{50}$, $R_{40}$) sont adaptés pour favoriser la transmission de signaux électriques des bandes VHF-UHF et atténuer au moins les signaux électriques de fréquence inférieure à la bande d'utilisation.

3. Circuit amplificateur selon l'une des revendications 1 ou 2, caractérisé par le fait que le transistor ($T_{10}$) de l'étage amplificateur est monté en émetteur commun.

4. Circuit amplificateur selon l'une des revendications 1 à 3, caractérisé par le fait que le réseau d'adaptation de sortie comprend un réseau parallèle résistance-capacité ($R_{40}$-$C_{50}$) qui relie le collecteur du transistor ($T_{10}$) à la sortie (20) du circuit amplificateur.

5. Circuit amplificateur selon l'une des revendications 1 à 4, caractérisé par le fait que la boucle de contre-réaction en tension ($R_{10}$, $S_{10}$) et le réseau d'adaptation d'entrée ($C_{20}$, $C_{30}$) sont adaptés pour fixer en combinaison l'impédance d'entrée du circuit amplificateur et linéariser la réponse de celui-ci dans la partie inférieure de la bande d'utilisation.

6. Circuit amplificateur selon l'une des revendications 1 à 5, caractérisé par le fait que le réseau d'adaptation de sortie ($R_{40}$, $C_{50}$) est adapté pour fixer l'impédance de sortie du circuit amplificateur et linéariser la réponse de celui-ci dans la partie supérieure de la bande d'utilisation.

7. Circuit amplificateur selon l'une des revendications 1 à 6, caractérisé par le fait que le réseau d'adaptation d'entrée comprend deux capacités ($C_{20}$, $C_{30}$) connectées en série entre l'entrée du circuit et la masse, le point commun médian des capacités étant relié à la base du transistor ($T_{10}$).

8. Circuit amplificateur selon l'une des revendications 1 à 7, caractérisé par le fait que la boucle de contre-réaction comprend en série une résistance ($R_{10}$) et une self ($S_{10}$).

9. Circuit amplificateur selon l'une des revendications 1 à 8, caractérisé par le fait qu'il est réalisé en technologie hybride.

10. Dispositif de traitement de signaux électriques, en particulier dispositif de réception, caractérisé par le fait qu'il comprend au moins un circuit amplificateur conforme à l'une des revendications 1 à 9.

## Claims

1. Wide band amplifier circuit for electrical signals, in particular for VHF-UHF bands, of the type comprising at least :
   an amplifier arrangement comprising
   an amplifier stage comprising a transistor ($T_{10}$) which does not have a negative feedback of current in the utilisation band, and
   an input adaptation system ($C_{20}$, $C_{30}$),
   an output adaptation system ($C_{50}$, $R_{40}$), characterised by the fact that it also comprises a voltage negative feedback loop ($S_{10}$, $R_{10}$) acting on the amplifier arrangement composed of the amplifier stage comprising a transistor ($T_{10}$) and the input adaptation system ($C_{20}$, $C_{30}$).

2. Amplifier circuit according to Claim 1, characterised by the fact that the said input system ($C_{20}$, $C_{30}$) and output system ($C_{50}$, $R_{40}$) are adapted to promote the transmission of electrical signals of the VHF-UHF bands and to attenuate at least the electrical signals of frequency lower than the utilisation band.

3. Amplifier circuit according to one of Claims 1 or 2, characterised by the fact that the transistor ($T_{10}$) of the amplifier stage is connected as a common emitter.

4. Amplifier circuit according to one of Claims 1 to 3, characterised by the fact that the output adaptation system comprises a parallel resistance-capacitance system ($R_{40}$-$C_{50}$) which connects the collector of the transistor ($T_{10}$) to the output (20) of the amplifier circuit.

5. Amplifier circuit according to one of Claims 1 to 4, characterised by the fact that the voltage negative feedback loop ($R_{10}$, $S_{10}$) and the input adaptation system ($C_{20}$, $C_{30}$) are adapted to fix in combination the input impedance of the amplifier circuit and to make the response of the latter linear in the lower part of the utilisation band.

6. Amplifier circuit according to one of Claims 1 to 5, characterised by the fact that the output adaptation system ($R_{40}$, $C_{50}$) is adapted to fix the output impedance of the amplifier circuit and make the response of the latter linear in the upper part of the utilisation band.

7. Amplifier circuit according to one of Claims 1 to 6, characterised by the fact that the input adaptation system comprises two capacitances ($C_{20}$, $C_{30}$) connected in series between the input of the circuit and earth, the median common point of the capacitances being connected to the base of the transistor ($T_{10}$).

8. Amplifier circuit according to one of Claims 1 to 7, characterised by the fact that the negative feedback loop comprises in series a resistance ($R_{10}$) and a self-induction coil ($S_{10}$).

9. Amplifier circuit according to one of Claims 1 to 8, characterised by the fact that it is produced with hybrid technology.

10. Device for processing electrical signals, in particular receiving device, characterised by the fact that it comprises at least one amplifier circuit according to one of Claims 1 to 9.

## Patentansprüche

1. Breitbandverstärker, insbesondere VHF-UHF-Breitbandverstärker für elektrische Signale, der mindestens umfaßt :

— eine Verstärkeranordnung, bestehend aus einer Transistor-Verstärkerstufe ($T_{10}$) ohne Strom-Gegenkopplung innerhalb des Einsatzbandes, und einem Netz ($C_{20}$, $C_{30}$) zur Eingangsanpassung, und

— ein Netz ($C_{50}$, $R_{40}$) zur Ausgangsanpassung, gekennzeichnet durch einen Zweig ($S_{10}$, $R_{10}$) zur Spannungs-Gegenkopplung, der auf die Verstärkeranordnung wirkt, die sich aus der Transistor-Verstärkerstufe ($T_{10}$) und dem Netz ($C_{20}$, $C_{30}$) zur Eingangsanpassung zusammensetzt.

2. Breitbandverstärker nach Anspruch 1, dadurch gekennzeichnet, daß das Netz ($C_{20}$, $C_{30}$) zur Eingangsanpassung und das Netz ($C_{50}$, $R_{40}$) zur Ausgangsanpassung so ausgelegt sind, daß sie die Übertragung von elektrischen Signalen im VHF/UHF-Bereich begünstigen und mindestens solche elektrischen Signale dämpfen, deren Frequenz unterhalb des Einsatzbandes liegt.

3. Breitbandverstärker nach Anspruch 1 oder 2, dadurch gekennzeichnet, daß der Transistor ($T_{10}$) der Verstärkerstufe in Emitterschaltung verschaltet ist.

4. Breitbandverstärker nach einem der Ansprüche 1 bis 3, dadurch gekennzeichnet, daß das Netz zur Ausgangsanpassung eine parallelschaltung ($R_{40}$, $C_{50}$) eines Widerstandes und eines Kondensators umfaßt, die den Kollektor des Transistors ($T_{10}$) mit dem Ausgangsanschluß (20) des Breitbandverstärkers verbindet.

5. Breitbandverstärker nach einem der Ansprüche 1 bis 4, dadurch gekennzeichnet, daß der Zweig ($S_{10}$, $R_{10}$) zur Spannungs-Gegenkopplung und das Netz ($C_{20}$, $C_{30}$) zur Eingangsanpassung dazu ausgelegt sind, daß sie zusammen die Eingangsimpedanz des Breitbandverstärkers festlegen und die Antwort desselben in dem unteren Bereich des Einsatzbandes linearisieren.

6. Breitbandverstärker nach einem der Ansprüche 1 bis 5, dadurch gekennzeichnet, daß das Netz ($R_{40}$, $C_{50}$) zur Ausgangsanpassung dazu ausgelegt ist, die Ausgangsimpedanz des Breitbandverstärkers festzulegen und die Antwort desselben in dem höheren Bereich des Einsatzbandes zu linearisieren.

7. Breitbandverstärker nach einem der Ansprüche 1 bis 6, dadurch gekennzeichnet, daß das Netz zur Eingangsanpassung zwei Kondensatoren ($C_{20}$, $C_{30}$) umfaßt, die in Serie zwischen dem Eingang des Breitbandverstärkers und Masse liegen, wobei der gemeinsame Verbindungspunkt der Kondensatoren an die Basis des Transistors ($T_{10}$) angeschlossen ist.

8. Breitbandverstärker nach einem der Ansprüche 1 bis 7, dadurch gekennzeichnet, daß der Zweig zur Gegenkopplung in Serie einen Widerstand ($R_{10}$) une eine Spule ($S_{10}$) umfaßt.

9. Breitbandverstärker nach einem der Ansprüche 1 bis 8, dadurch gekennzeichnet, daß er in Hybrid-Technik aufgeführt ist.

10. Verarbeitungseinrichtung für elektrische Signale, insbesondere Empfangseinrichtung, gekennzeichnet durch mindestens einen Breitbandverstärker nach einem der Ansprüche 1 bis 9.

FIG – 1

Etat de la Technique

FIG – 2

FIG – 3